# EUROPÄISCHE PATENTSCHRIFT

(11) **EP 1 913 694 B1**
(45) Veröffentlichungstag und Bekanntmachung des Hinweises auf die Patenterteilung: **13.01.2010**
(21) Anmeldenummer: 06818004.1
(22) Anmeldetag: 11.08.2006
(51) Int. Cl.: H03K 17/22

(54) **SCHALTUNGSANORDNUNG ZUR ERZEUGUNG EINES DEFINIERTEN AUSGANGSSIGNALS**
CIRCUIT ARRANGEMENT FOR PRODUCING A DEFINED OUTPUT SIGNAL
ENSEMBLE CIRCUIT POUR LA PRODUCTION D'UN SIGNAL DE SORTIE DEFINI

(30) Priorität: 11.08.2005 DE 102005038316
(43) Veröffentlichungstag der Anmeldung: 23.04.2008
(73) Patentinhaber: Zentrum Mikroelektronik Dresden AG, 01109 Dresden (DE)
(72) Erfinder: KRAUSS, Mathias, Centerport, New York 11721 (US)
(74) Vertreter: Lippert, Stachow & Partner
(86) Internationale Anmeldenummer: PCT/DE2006/001412
(87) Internationale Veröffentlichungsnummer: WO 2007/016923

(56) Entgegenhaltungen:
- US-A- 5 877 635
- US-A1- 2002 089 382
- US-B1- 6 650 156

## Beschreibung

Die Erfindung betrifft eine Schaltungsanordnung zur Erzeugung eines definierten Ausgangssignals in einem CMOS-Schaltkreis, welcher eine Sensorsignal Konditiönierungs-Schaltung mit einem Ausgang zur Ausgabe eines Ausgangssignals aufweist, wobei der Ausgang mit einem ersten Anschluss eines Lastwiderstands und der zweite Anschluss des Lastwiderstands mit einem Potential VDD verbunden ist.

Die Erfindung betrifft auch eine Schaltungsanordnung zur Erzeugung eines definierten Ausgangssignals in einem CMOS-Schaltkreis, welcher eine Sensorsignal Konditionierungs-Schaltung mit einem Ausgang zur Ausgabe eines Ausgangssignals aufweist, wobei der Ausgang mit einem ersten Anschluss eines Lastwiderstands und der zweite Anschluss des Lastwiderstands mit einem Potential VSS verbunden ist.

Schaltkreise zur Konditionierung von Sensorsignalen haben die Aufgabe, die mehr oder weniger fehlerbehafteten Rohsignale von Sensoren in ein Standardausgangssignal zu überführen, das von diesen Fehlern befreit ist. Ein häufig anzutreffender Standard ist der ratiometrische Spannungsausgang. Bei diesem wird der interessierende Bereich des Eingangssignals, beispielsweise ein Winkel von 50 Grad bis 150 Grad eines Winkelsensors oder der Druck von 0 bis 200 bar an einem Drucksensor, in eine Ausgangsspannung von beispielsweise 5% bis 95% der Versorgungsspannung umgesetzt.

Der Standard des ratiometrischen Spannungssignals hat seinen Ursprung in einfachen potentiometrischen Sensoren. Kompatibilitätsforderungen machen es notwendig, das moderne CMOS Schaltkreise sich bei bestimmten Fehlerfällen genau so verhalten, wie ihre Vorgänger, die Potentiometer.

Insbesondere besteht die Forderung, dass bei Unterbrechung einer der Anschlussleitungen VDD und GND, dem so genannten "power loss" Fall, im Zusammenspiel mit dem noch angeschlossenen Lastwiderstand, ein Ausgangssignal in einen der beiden so genannten Diagnosebereiche, unterhalb 2.5% oder oberhalb 97.5% der Versorgungsspannung entsteht.

Um diesem Verhalten, das sich bei einem Potentiometer auf natürliche Weise ergibt, mit einem CMOS Schaltkreis ohne Verwendung zusätzlicher externer Bauelemente zu entsprechen, sind spezielle schaltungstechnische Lösungen erforderlich.

Die dem Stand der Technik entsprechende Lösung besteht darin, zunächst die Unterbrechung der Versorgungsspannung zu detektieren und im Anschluss daran den Schaltkreis in einen hochohmigen Zustand zu bringen, der es ermöglicht, im Zusammenwirken mit einem pull down Lastwiderstand im Falle von "loss of VSS" eine Ausgangsspannung kleiner als 2.5% von VDD oder mit einem pull up Lastwiderstand im Falle von "loss of VDD" eine Ausgangsspannung größer als 97.5% zu erzeugen.

Dabei müssen die nachfolgend beschriebenen Problemstellungen beachtet werden.

Die Diagnose Schaltung, als ein Bestandteil des Schaltkreises, muss, um in den Diagnosezustand zu gelangen, während der Unterbrechung einer der Versorgungsspannungsanschlüsse weiterhin bestimmte Funktionen ausführen. Bevor die Versorgungsspannung aufgrund des Eigenstrombedarfes des Schaltkreis unter einen bestimmten Wert gesunken ist, muss die Umschaltung des gesamten Schaltkreises in eine stromarmen Zustand (Power-Down) erfolgt sein, damit eine Versorgung des Schaltkreises über den Lastwiderstand und die parasitären Substrat- oder Wannendioden gewährleistet werden kann. Diesen Umschaltvorgang unter verschiedenen Randbedingungen wie Größe des Lastwiderstandes und der Lastkapazität sowie weitestgehend undefiniertem Flankenverlauf der Unterbrechung sicher zu beherrschen, ist technisch aufwendig.

Die Realisierung eines Power-Down-Zustandes mit extrem geringem Reststrom für den gesamtem Schaltkreis erfordert schaltungstechnische Maßnahmen in jedem einzelnen Schaltungsblock, die zum Teil nur zu Lasten des Gesamtfehlerbudgets kritischer analoger Schaltungsteile erreichbar sind. Weiterhin stellt die Verflechtung der Diagnoseschaltung mit allen Schaltungsteilen eine zusätzliches, nicht zu unterschätzendes Entwurfsrisiko für die korrekte Funktion aller anderen Steuerungsabläufe dar.

Unter realen Bedingungen, insbesondere bei Anwendungen im Automobil, ist es problematisch den Power-Down-Reststrom auch für Temperaturen von 150C und mehr sicher unter einem Wert zu halten, der im Zusammenwirken mit dem Lastwiderstand die Einhaltung der Diagnosepegel (<2.5% VDD bzw. >97.5% VDD) gewährleistet. Um dieses Problem zu beherrschen, muss eine sonst unübliche Maximalgrenze des Lastwiderstandes spezifiziert werden, was in der Praxis zu einem eingeschränkten Anwendungsbereich des Schaltkreises führt.

Der Erfindung liegt somit die Aufgabe zugrunde, eine Schaltungsanordnung zur Erzeugung eines definierten Ausgangssignals in einem CMOS-Schaltkreis anzugeben, mit welcher eine robuste, vom übrigen Schaltkreis weitestgehend unabhängig arbeitende Diagnose einer Unterbrechung des VDD- oder GND-Anschlusses realisiert wird, die weder eine obere Begrenzung des Lastwiderstandes erfordert noch die obere Betriebstemperatur des Schaltkreises einschränkt und auf dem Chip selbst realisiert werden kann.

Gemäß der Erfindung wird die Aufgabe bei einer Schaltungsanordnung zur Erzeugung eines definierten Ausgangssignals der eingangs genannten Art dadurch gelöst, dass der Ausgang der Sensorsignal Konditionierungs-Schaltung mit einem Drain-Anschluss eines ersten N-Kanal-Depletion-Transistors, einem Source-Anschluss eines zweiten N-Kanal-Depletion-Transistor und dem Ausgang (OUT) des CMOS-Schaltkreis verbunden ist, dass die Gate-Anschlüsse des ersten und des zweiten N-Kanal-Depletion-Transistors mit einem Ausgang (VP) einer Steuerschaltung und einem ersten Anschluss eines Ableitwiderstands verbunden sind, dass ein zweiter Anschluss des Ableitwiderstands und ein Source-Anschluss des ersten N-Kanal-Depletion-Transistors mit dem Potential VSS verbunden sind und dass ein Drain-Anschluss des zweiten N-Kanal-Depletion-Transistor mit dem Potential VDD verbunden ist.

Das Wesen der Erfindung wird unter Zugrundelegen eines CMOS Prozesses mit P-Substrat und N-Wanne erläutert. Erfindungsgemäß wird ein erster N-Kanal-Depletion-Transistor mit seinem Drain Anschluss mit dem Ausgang OUT des Schaltkreises, mit seinem Source-Anschluss mit der negativen Betriebsspannung VSS und mit seinem Gate-Anschluss mit dem Ausgang VP einer Steuerschaltung verbunden. Weiterhin wird ein zweiter N-Kanal-Depletion-Transistor mit seinem Drain-Anschluss mit VDD, mit seinem Source-Anschluss mit dem Ausgang OUT und mit seinem Gate-Anschluss ebenfalls mit dem Ausgang VP der Steurschaltung verbunden. Die Steuerschaltung ist eine Ladungspumpe, die an ihrem Ausgang VP eine gegenüber VSS negative Spannung bereitstellt, die ihrem Betrag nach größer ist als der Betrag der negativen Schwellspannung der beiden N-Kanal-Depletion-Transistoren. Erfindungsgemäß verbindet ein hochohmiger Widerstand den Ausgang VP der Steuerschaltung mit dem Potential VSS.

Die Erfindung soll nachfolgend anhand zweier Ausführungsbeispiele näher erläutert werden. In den zugehörigen Zeichnungen zeigt
- Fig. 1: die erfindungsgemäße Schaltungsanordnung mit einem Pull-Up-Last-Widerstand und
- Fig. 2: die erfindungsgemäße Schaltungsanordnung mit einem Pull-Down-Last-Widerstand.

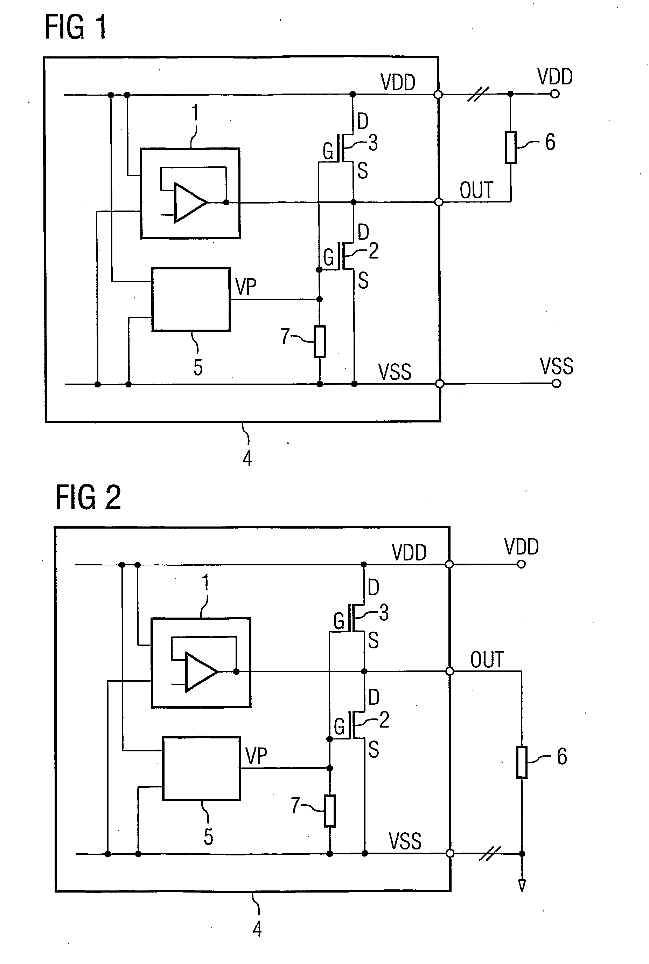

Die Figur 1 zeigt die erfindungsgemäße Schaltungsanordnung welche mit einem Pull-Up-Last-Widerstand arbeitet.

Die Schaltungsanordnung besteht aus der eigentlichen Sensorschaltung 1, welche beispielsweise eine Druck- oder Temperatursensor ist, mit den Betriebsspannungen VDD und VSS oder einem Masse-Potential verbunden ist und die einen Ausgang OUT zur Ausgabe eines, in den meisten Fällen ratiometrischen, Ausgangssignals aufweist. Am Ausgang OUT ist ein Lastwiderstand 6 entweder wie dargestellt gegen das Potential VSS als Pull-Down-Widerstand oder gegen das Potential VDD als Pull-Up-Widerstand geschaltet.

Ein erster N-Kanal-Depletion-Transistor 2 ist mit seinem Drain-Anschluss mit dem Ausgang OUT des Schaltkreises 4 , mit seinem Source-Anschluss mit der negativen Betriebsspannung VSS und mit seinem Gate-Anschluss mit dem Ausgang VP einer Steuerschaltung 5 verbunden. Zwischen dem Ausgang VP der Steuerschaltung 5 und dem Potential VSS ist ein Ableitwiderstand 7 angeordnet. Der Transistor 2 verbindet bei einem in der Figur 1 dargestellten Abriss des Betriebsspannungsanschlusses VDD, innerhalb oder außerhalb des Schaltkreises 4, den Ausgang OUT mit dem Potential VSS.

Für den Fall, dass der Lastwiderstand 6 als Pull-Up-Widerstand geschaltet ist, bildet der Lastwiderstand 6 und der niederohmige N-Kanal-Depletion-Transistor 2 einen Spannungsteiler, der eine Ausgangsspannung < 2.5% von VDD am Ausgang OUT erzeugt, die gleichzeitig die gesamte über dem Schaltkreis abfallende Spannung darstellt, wodurch auch die Steuerschaltung 5 nicht mehr arbeitet und der Ableitwiderstand 7 das Gate des N-Kanal-Depletion-Transistors 2 mit VSS verbindet. Dies ist möglich, da der N-Kanal-Depletion-Transistor 2 ohne Steuerspannung am Gate selbstleitend ist.

Die Figur 2 zeigt eine erfindungsgemäße Schaltungsanordnung, welche mit einem Pull-Down-Widerstand arbeitet. Auch dieseer Schaltkreis hat den gleichen wie bereits oben beschriebenen Aufbau.

Für dieses Beispiel wird der Fall einer Unterbrechung der VSS-Leitung innerhalb oder außerhalb der Sensorsignal Konditionierungs-Schaltung 1 angenommen.

Der zweite N-Kanal-Depletion-Transistor 3 ist mit seinem Drain-Anschluss mit VDD, mit seinem Source-Anschluss mit dem Ausgang OUT und mit seinem Gate-Anschluss mit dem Ausgang VP der Steuerschaltung 5 verbunden. Dieser Transistor verbindet bei einem Abriss der Spannungsleitung VSS den Ausgang OUT mit dem Potential VDD.

Für den Fall, dass der Lastwiderstand 6 als ein Pull-Down-Widerstand ausgebildet ist, bildet dieser Lastwiderstand 6 und der niederohmige zweite N-Kanal-Depletion-Transistor 3 einen. Spannungsteiler, wobei eine Ausgangsspannung > 97.5% des Potentials von VDD am Ausgang OUT der Anordnung erzeugt wird. Dies ist möglich, da der N-Kanal-Depletion-Transistor 3 ohne Steuerspannung am Gate selbstleitend ist. Hierbei stellt die Differenz dieser Spannung zu VDD gleichzeitig die gesamte über dem Schaltkreis abfallende Spannung dar, wodurch auch die Steuerschaltung 5 nicht mehr arbeitet und der Ableitwiderstand 7 das Gate des zweiten N-Kanal-Depletion-Transistors 3 mit dem nun offenen VSS Anschluss des IC verbindet.

Somit ist in beiden Diagnosefällen kein Teil des Schaltkreises 4 aktiv und die selbstleitenden N-Kanal-Depletion-Transistoren 2 und 3 garantieren bei entsprechender Dimensionierung die vorgeschriebenen Diagnosepegel. Zur Einhaltung dieser Pegel ist eine Begrenzung des Lastwiderstandes 6 nach unten erforderlich, wie dies üblicherweise auch durch die begrenzte Treiberfähigkeit eines Ausgangsbuffers gegeben ist. Die Steuerschaltung 5 ist als Ladungspumpe ausgebildet und stellt an ihrem Ausgang VP eine gegenüber dem Potential VSS negative Spannung bereit. Diese Spannung ist ihrem Betrag nach größer als der Betrag der negativen Schwellspannung der beiden N-Kanal-Depletion-Transistoren. Somit wird im normalen Betrieb ein sicheres Sperren der N-Kanal-Depletion-Transistoren 2 und 3 garantiert, wodurch eine zusätzliche Belastung des Ausgangsbuffers der Sensorsignal Konditionierungs-Schaltung 1 verhindert wird.

### Bezugszeichenliste

- 1: Sensorsignal Konditionierungs-Schaltung
- 2: erster N-Kanal-Depletion-Transistor .
- 3: zweiter N-Kanal-Depletion-Transistor
- 4: Schaltkreis
- 5: Steuerschaltung
- 6: Lastwiderstand
- 7: Ableitwiderstand

## Patentansprüche

1. Schaltungsanordnung zur Erzeugung eines definierten Ausgangssignals in einem CMOS-Schaltkreis, welcher eine Sensorsignal Konditionierungs-Schaltung mit einem Ausgang zur Ausgabe eines Ausgangssignals aufweist, wobei der Ausgang mit einem ersten Anschluss eines Lastwiderstands und der zweite Anschluss des Lastwiderstands mit einem Potential VDD verbunden ist, **dadurch gekennzeichnet, dass** der Ausgang der Sensorsignal Konditionierungs-Schaltung (1) mit einem Drain-Anschluss eines ersten N-Kanal-Depletion-Transistors (2), einem Source-Anschluss eines zweiten N-Kanal-Depletion-Transistor (3) und dem Ausgang (OUT) des CMOS-Schaltkreis (4) verbunden ist, dass die Gate-Anschlüsse des ersten und des zweiten N-Kanal-Depletion-Transistors (2 und 3) mit einem Ausgang (VP) einer Steuerschaltung (5) und einem ersten Anschluss eines Ableitwiderstands (7) verbunden sind, dass ein zweiter Anschluss des Ableitwiderstands (7) und ein Source-Anschluss des ersten N-Kanal-Depletion-Transistors (2) mit dem Potential VSS verbunden sind und dass ein Drain-Anschluss des zweiten N-Kanal-Depletion-Transistor (3) mit dem Potential VDD verbunden ist.

2. Schaltungsanordnung zur Erzeugung eines definierten Ausgangssignals in einem CMOS-Schaltkreis, welcher eine Sensorsignal Konditionierungs-Schaltung mit einem Ausgang zur Ausgabe eines Ausgangssignals aufweist, wobei der Ausgang mit einem ersten Anschluss eines Lastwiderstands und der zweite Anschluss-des Lastwiderstands mit einem Potential VSS verbunden ist, **dadurch gekennzeichnet, dass** der Ausgang der Sensorsignal Konditionierungs-Schaltung (1) mit einem Drain-Anschluss eines ersten N-Kanal-Depletion-Transistors (2), einem Source-Anschluss eines zweiten N-Kanal-Depletion-Transistor (3) und dem Ausgang (OUT) des CMOS-Schaltkreis (4) verbunden ist, dass die Gate-Anschlüsse des ersten und des zweiten N-Kanal-Depletion-Transistors (2 und 3) mit einem Ausgang (VP) einer Steuerschaltung (5) und einem ersten Anschluss eines Ableitwiderstands (7) verbunden sind, dass ein zweiter Anschluss des Ableitwiderstands (7) und ein Source-Anschluss des ersten N-Kanal-Depletion-Transistors (2) mit dem Potential VSS verbunden sind und dass ein Drain-Anschluss des zweiten N-Kanal-Depletion-Transistor (3) mit dem Potential VDD verbunden ist.

3. Anordnung nach Anspruch 1 oder 2, **dadurch gekennzeichnet, dass** die Steuerschaltung (5) eine Ladungspumpe ist.

## Claims

1. Circuit arrangement for producing a defined output signal in a CMOS circuit which comprises a sensor signal conditioning circuit having an output for outputting an output signal, the output being connected to a first terminal of a load resistor and the second terminal of the load resistor being connected to a potential VDD, **characterised in that** the output of the sensor signal conditioning circuit (1) is connected to a drain terminal of a first N-channel depletion transistor (2), a source terminal of a second N-channel depletion transistor (3) and the output (OUT) of the CMOS circuit (4), **in that** the gate terminals of the first and second N-channel depletion transistors (2 and 3) are connected to an output (VP) of a control circuit (5) and a first terminal of a shunt resistor (7), **in that** a second terminal of the shunt resistor (7) and a source terminal of the first N-channel depletion transistor (2) are connected to the potential VSS, and **in that** a drain terminal of the second N-channel depletion transistor (3) is connected to the potential VDD.

2. Circuit arrangement for producing a defined output signal in a CMOS circuit which comprises a sensor signal conditioning circuit having an output for outputting an output signal, the output being connected to a first terminal of a load resistor and the second terminal of the load resistor being connected to a potential VSS, **characterised in that** the output of the sensor signal conditioning circuit (1) is connected to a drain terminal of a first N-channel depletion transistor (2), a source terminal of a second N-channel depletion transistor (3) and the output (OUT) of the CMOS circuit (4), **in that** the gate terminals of the first and second N-channel depletion transistors (2 and 3) are connected to an output (VP) of a control circuit (5) and a first terminal of a shunt resistor (7), **in that** a second terminal of the shunt resistor (7) and a source terminal of the first N-channel depletion transistor (2) are connected to the potential VSS, and **in that** a drain terminal of the second N-channel depletion transistor (3) is connected to the potential VDD.

3. Arrangement according to either claim 1 or claim 2, **characterised in that** the control circuit (5) is a charge pump.

## Revendications

1. Circuit pour générer un signal de sortie défini dans un montage CMOS comportant un circuit de conditionnement de signal de capteur avec une sortie pour émettre un signal de sortie,
la sortie étant reliée au premier branchement d'une résistance de charge dont le second branchement est mis à un potentiel VDD,
**caractérisé en ce que**
la sortie du circuit de conditionnement (1) de signal de capteur est reliée à la borne de drain d'un premier transistor (2) à canal N à déplétion, à la borne de source d'un second transistor (3) à canal N à déplétion et à la sortie OUT du montage CMOS (4),
les bornes de porte du premier et du second transistor (2, 3) à canal N à déplétion sont reliées à la sortie VP d'un circuit de commande (5) et à la première borne d'une résistance de division (7),
la seconde borne de la résistance de division (7) et la borne de source du premier transistor (2) à canal N à déplétion sont reliées au potentiel VSS, et
la borne de drain du second transistor (3) à canal N à déplétion est reliée au potentiel VDD.

2. Circuit pour générer un signal de sortie défini dans un montage CMOS comportant un circuit de conditionnement de signal de capteur avec une sortie pour émettre un signal de sortie,
la sortie étant reliée au premier branchement d'une résistance de charge dont le second branchement est mis à un potentiel VSS,
**caractérisé en ce que**
la sortie du circuit de conditionnement (1) de signal de capteur est reliée à la borne de drain d'un premier transistor (2) à canal N à déplétion, à la borne de source d'un second transistor (3) à canal N à déplétion et à la sortie OUT du montage CMOS (4),
les bornes de porte du premier et du second transistor (2, 3) à canal N à déplétion étant reliées à la sortie VP d'un circuit de commande (5) et à la première borne d'une résistance de division (7),
la seconde borne de la résistance de division (7) et la borne de source du premier transistor (2) à canal N à déplétion étant reliées au potentiel VSS, et
la borne de drain du second transistor (3) à canal N à déplétion étant reliée au potentiel VDD.

3. Circuit selon la revendication 1 ou 2,
**caractérisé en ce que**
le circuit de commande (5) est une pompe d'alimentation.
